Europäisches Patentamt

European Patent Office

Office européen des brevets

(11) Publication number: **0 049 799**

**B1**

# EUROPEAN PATENT SPECIFICATION

(45) Date of publication of patent specification: **12.02.86**

(51) Int. Cl.⁴: **G 03 F 1/00**

(21) Application number: **81107702.3**

(22) Date of filing: **28.09.81**

(54) **Photomask blank and photomask.**

(30) Priority: 09.10.80 JP 141565/80
28.02.81 JP 28721/81
28.02.81 JP 28722/81
07.05.81 JP 68693/81
07.05.81 JP 68694/81

(43) Date of publication of application:
**21.04.82 Bulletin 82/16**

(45) Publication of the grant of the patent:
**12.02.86 Bulletin 86/07**

(84) Designated Contracting States:
**CH DE FR LI**

(56) References cited:
**GB-A-1 239 768**
**US-A-3 622 319**
**US-A-4 139 443**
**US-A-4 166 148**
**US-A-4 178 403**

(73) Proprietor: **DAI NIPPON INSATSU KABUSHIKI KAISHA**
**1-1, Kaga-Cho 1-Chome Ichigaya Shinjuku-Ku Tokyo 162 (JP)**

(72) Inventor: **Kaneki, Satoru**
**11-202, Sayama Guriin Haitsu 213, Sasai Sayama-Shi Saitama-Ken (JP)**
Inventor: **Tabuchi, Kazuhiro**
**27-206, Fujimi 3-Chome Tsurugashima-Machi Iruma-Gun Saitama-Ken (JP)**

(74) Representative: **Patentanwälte Dipl.-Ing. Klaus Behn Dipl.-Phys. Robert Münzhuber Widenmayerstrasse 6/IV D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates generally to photomask blanks and photomasks for use in the production of semiconductors, integrated circuits (IC), large-scale integrated circuits (LSI), and like electronic components. More specifically, this invention relates to photomasks of the type generally called hard masks and to their blanks.

In general, a photomask blank is fabricated by forming on an outer surface of a transparent substrate a thin metal film or, in place thereof, a thin film of a masking material by a process such as vacuum evaporation or sputtering. By applying a photolithographic process including the steps of forming a photoresist film, pattern exposure to light, and etching to this photomask blank, a film of the above mentioned metal or masking material is left in the form of a pattern such as a pattern of a circuit for an IC or an LSI on the transparent substrate thereby to produce a photomask.

This photomask is superposed on a semiconductor wafer and thus used for pattern transfer exposure, but since the photomask is actually an expendable article, the common practice at present is to fabricate beforehand a master mask or, further, a sub-master mask and, with the use of this master mask or sub-master mask, to fabricate masks for transferring patterns onto semiconductor wafers. For reasons of cost, photomasks having a silver emulsion film as a light-screening or masking film are frequently used as photomasks for pattern transfer. A circuit pattern on the above mentioned hard mask comprises a film of a material such as metallic chromium or chromium oxide is scattered state on a glass plate. This film is not necessarily continuous over its entire extension, there being parts existing in isolated island-like state on the glass plate. A problem arises in the following two cases as described below. The first case is that wherein this hard mask is used as a master mask or a sub-master mask and caused to contact a mask blank having a silver emulsion film, onto which the circuit pattern of the master mask is transferred. The second case is that wherein the circuit pattern of a mask is caused to contact a semiconductor wafer which has been coated with a resist thereby to transfer the circuit pattern.

In each of these cases, static electricity is generated by friction at the time of intimate contact and peeling off, and a discharge phenomenon occurs between the pattern parts of the hard mask. Consequently, particularly at the peripheral parts of the film comprising metallic chromium, a chromium oxide, or the like of the above mentioned island-like parts of the pattern, portions of the film are observed to have dropped off and are missing. Even small portions which are thus missing give rise to a complete loss of the function of the master mask, whereby this result is a fatal defect.

Furthermore, photomasks known in the prior art have exposed portions of the substrate outer surface. These exposed portions have lower surface strength than film portions and are subject to so-called staining during storage. Portions in which staining has occurred area easily damaged, in general, and lead to a lowering of the resolution of the mask.

Another problem is that, when the photomask is brought into intimate contact with a semiconductor wafer for exposure to light, the portions in which staining has occurred are very easily scratched or scored by the concavities and convexities of the semiconductor surface, dust, and other causes. Consequently, in spite of the use of the film of metallic chromium, chromium oxide, or the like for the light-screening film especially for their high value of surface hardness, the strength and durability of the entire hard mask is determined by those of the transparent substrate.

Still another difficulty is that, because of the accumulation of electrostatic charge during use a result of repeated use, dust readily adheres to give rise to problems such as impairment of the intimate contact with the wafer and scratching of surfaces due to the dust.

Furthermore, together with miniaturization and denser arrangement of semiconductor devices, extremely high degrees of image quality and dimensional precision of the photomasks therefor become necessary. For this reason, in place of the ordinary photographic inspection, the electron beam inspection is coming into use. However, since photomasks after patterning are generally insulative along the expanse thereof, the parts irradiated by electron beam are charged and the accuracy of inspection is lowered to an impractical level.

In order to avoid the above difficulties, it has been proposed to use a photomask wherein an electroconductive film made of an oxide such as indium oxide and tin oxide is interposed between a transparent substrate and a masking film (U.S. Patent No. 4178403). According to this mask, the above mentioned difficulties resulting from the insulative property of photomasks can be obviated. However, electroconductive photomasks of this type accompany the following other difficulties and are not practically satisfactory.

Firstly, the oxide electroconductive films as mentioned above do not have a sufficient chemical resistance and are readily attacked by a chromic acid mixture solution, a mixture solution of $H_2SO_4 + H_2O_2$ and a mixture solution of benzenesulfonic acid and a phenol which are generally used as cleaning solutions for photomasks, whereby not only the transparency of parts not covered by the masking film is considerably changed but also the oxide electroconductive films are caused to dissolve in a relatively short time and lose their conductivity. These oxide films, of course, have a sufficient resistance to organic solvent, whereas it is, as is well-known in the art, extremely difficult to remove various kinds of stains adhering to photomasks with organic solvent. Secondly, these electroconductive oxide films have poor adhesiveness or stickiness to both glass substrates and masking films such as chromium films and are liable to form defects such as pin-holes. Furthermore, for the same reason, they generally have a poor scratch-resistance.

Because of these difficulties, this type of photomasks having an oxide electroconductive film generally fails to give an improved durability which hard masks are expected to provide for.

It is an object of this invention to overcome the problems encountered with respect to known hard masks as described above and thereby to provide photomask blanks and photomasks having high durability and, moreover, excellent applicability to the electron-beam inspection.

This invention contemplates the achievement of the above stated object by a multilayer construction produced by forming, on a transparent substrate as used in the prior art, a translucent film having electroconductivity by vacuum evaporation, sputtering, or electroless plating and further forming thereon a film of a material used heretofore as a material for mask such as metallic chromium, chromium oxide, metallic silicon, iron oxide, metallic tantalum, or tantalum oxide.

According to this invention in one aspect thereof, briefly summarized, there is provided a photomask blank comprising a transparent substrate, a metallic film of Ta on the substrate, and a masking film comprising at least one layer of a masking material selected from the group consisting of metallic chromium and chromium oxide and combination thereof on the metallic film.

According to this invention in another aspect thereof, there is provided a photomask blank comprising a transparent substrate, a metallic film of Cr on the substrate, and a masking film comprising at least one layer of a masking material selected from the group consisting of metallic tantalum and tantalum oxide and combination thereof on the metallic film.

According to this invention in a third aspect thereof, there is provided a photomask blank comprising a transparent substrate, a metallic film of a translucent and electroconductive material selected from the group consisting of Mo, Nb, Ta, Ti, V, W, Cr, Zr and Au on the substrate, a chemically resistant and translucent protective film of a material selected from the group consisting of aluminum oxide, calcium oxide, magnesium oxide, silicon oxide, silicon nitride, cerium oxide, tantalum oxide, chromium oxide, and titanium oxide on the metallic film, and a masking film comprising at least one layer of a masking material selected from the group consisting of metallic chromium, chromium oxide, chromium nitride, metallic silicon, iron oxide, metallic tantalum, tantalum oxide, tantalum nitride and combinations thereof on the protective film.

According to this invention in a forth aspect thereof, there is provided a photomask comprising a transparent substrate, a metallic film of Ta on the substrate, and a patternized masking film comprising at least one layer of a masking material selected from the group consisting of metallic chromium and chromium oxide and combination thereof on the metallic film.

According to this invention in a fifth aspect thereof, there is provided a photomask comprising a transparent substrate, a metallic film of Cr on the substrate, and a patternized masking film comprising at least one layer of a masking material selected from the group consisting of metallic tantalum and tantalum oxide and combination thereof on the metallic film.

According to this invention in still another aspect thereof, there is provided a photomask comprising a transparent substrate, a metallic film of a translucent and electroconductive material selected from the group consisting of Mo, Nb, Ta, Ti, V, W, Cr, Zr and Au on the substrate, a chemically resistant and translucent protective film of a material selected from the group consisting of aluminum oxide, calcium oxide, magnesium oxide, silicon oxide, silicon nitride, cerium oxide, tantalum oxide, chromium oxide, and titanium oxide on the metallic film, and a patternized masking film comprising at least one layer of a masking material selected from the group consisting of metallic chromium, chromium oxide, chromium nitride, metallic silicon, iron oxide, metallic tantalum, tantalum oxide, tantalum nitride and combinations thereof on the protective film.

Throughout this specification, the terms "translucent" (or "light-transmittancy" or "light-transmissive") and "masking" (or "light-screening") are intended to mean these characteristics with respect to light used in photolithography in a broad sense.

The nature, utility, and further features of this invention will be more clearly apparent from the following detailed description when read in conjunction with the accompanying drawing, briefly described below.

In the drawings:

Figs. 1 and 5 are schematic sectional views, respectively showing laminated structures of one example of the photomask blank according to this invention and one example of a photomask prepared from that photomask blank;

Figs. 2, 3 and 4 are schematic sectional views illustrating the steps for preparation of a photomask from a photomask blank; and

Figs. 6 and 7 are schematic sectional views, similar to Figs. 1 and 5, respectively showing the laminated structure of another example of the photomask blank and another example of the photomask prepared therefrom.

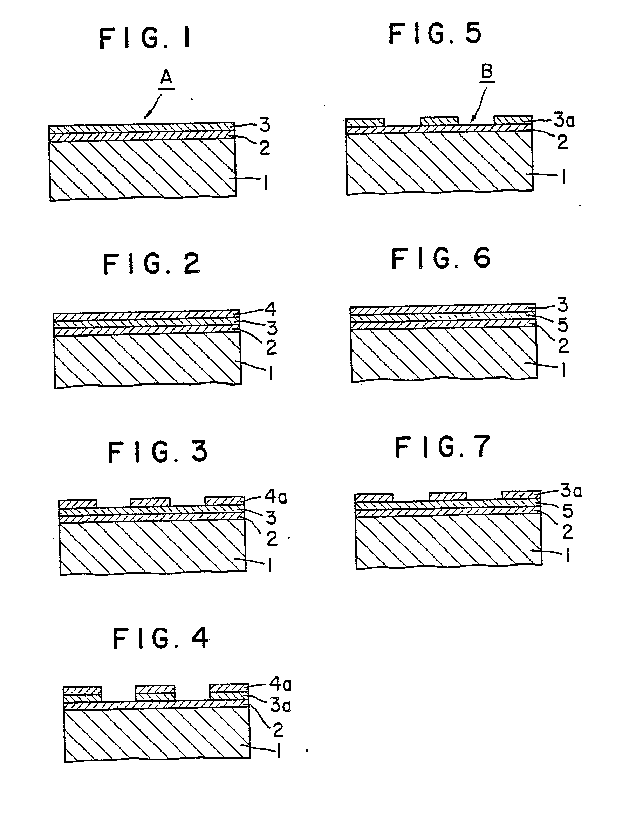

As shown in Fig. 1, a photomask blank A according to the present invention has an electroconductive metallic film 2 having translucency, and a masking film 3 laminated successively on a transparent substrate 1.

The transparent substrate 1 in the photomask blank A of this invention is made of any optically transparent material such as, for example, soda-lime glass, quartz glass, or sapphire. While there are essentially no limits to the thickness of this substrate, substrates of thicknesses of 0.2 to 6 mm are ordinarily used.

Next, the translucent metallic film having electroconductivity 2 formed on the transparent substrate must be one having the property of readily transmitting light therethrough and the property of readily conducting electricity therethrough. As for its transmittancy, a film having a transmittance of 60 percent or more with respect to light of a wavelength of 200 to 550 nm, particularly 400 to 550 nm, is preferable. An electrical resistivity of the film in terms of sheet resistivity of 50 K$\Omega$ per square or lower, specially 10 K$\Omega$ per square or lower, is desirable. Further, the thickness of this film is preferably 1 to 100 nm and more preferably 1 to 20 nm.

It is also necessary that the adhesiveness of this film relative to the masking film 3 which will be described in detail hereinafter and to the transparent substrate 1 be good. Another requirement is that, since the photomask is washed and repeatedly used, this film have a high chemical resistance with respect to acids, alkalis, and solvents to be used in the washing. Still another requirement is that this electroconductive film 2 have chemical resistance with respect also to etching agents for the masking film 3.

As a material for the electroconductive film 2 and for the masking film 3 having the above described characteristics, the materials as cited in claims 1, 2 and 4 are selected. The thickness of the masking film 4 is, for example, 30 to 200 nm and more preferably 600 to 200 nm.

Figs. 2 through 5 indicate the steps for production of a photomask of this invention with the use of a photomask blank of this invention. As shown in Fig. 2, a resist 4 is coated on the masking film 3. Then, exposure to light and development are carried out to form a resist pattern 4a as shown in Fig. 3. This step is followed by etching of the exposed portions of the masking film 3 as shown in Fig. 4. Finally, the resist 4a is peeled off to obtain a desired photomask B as shown in Fig. 5.

The etching of the masking film may be conducted by either the wet etching method or the dry etching method.

In the case of wet etching, it is possible to use an etchant which will etch the masking film without erosion of the electro-conductive film. Some examples of such an etchant are as follows.

Composition of etchant when the masking film is metallic chromium or chromium oxide

| | |
|---|---|
| $(NH_4)_2Ce(NO_3)_4$ | 165.0 g |
| $HClO_4$ (70%) | 43.0 ml |
| pure water | 1,000 ml |

Composition of etchant when the masking film is silicon

| | |
|---|---|
| $AgNO_3$ | 1.0 g |
| $NH_4F$ | 0.5 g |
| $HNO_3$ | 100 ml |
| pure water | 100 ml |

Composition of etchant when the masking film is iron oxide

| | |
|---|---|
| HCl | 300 ml |
| pure water | 100 ml |

Next, in the case of dry etching, it can be conducted by means of a parallel-plate type plasma-etching device under the conditions corresponding to the masking film as specified below.

Conditions when the masking film is metallic chromium or chromium oxide

| | |
|---|---|
| Etching gas: | mixture of $CCl_4$ and air |
| Gas pressure: | 0.3 Torr (1 Torr=133,3 Pa) |
| High-frequency power applied: | 200 W |
| Etching time: | 5 minutes |

Conditions when the masking film is silicon

| | |
|---|---|
| Etching gas: | $CF_4$ |
| Gas pressure: | 0.02 Torr |
| High-frequency power applied: | 250 W |
| Etching time: | 1 minute |

Conditions when the masking film is metallic tantalum or tantalum oxide

| | |
|---|---|
| Etching gas: | $CF_4$ |
| Gas pressure: | 0.01 Torr |
| High-frequency power applied: | 300 W |
| Etching time: | 2 minutes |

In the foregoing part of the disclosure, a basic example of the photomask blank and the photomask according to this invention has been described along with the method for production thereof. A photomask thus obtained is, however, subjected to repeated washing many times with a cleaning agent such as an acid or an alkali between the repeated use thereof, and it is therefore possible that the electroconductive film will be attacked by the cleaning agent, whereby the photomask will no longer be capable of performing as an electroconductive photomask. The corrosion of the electroconductive film 2 can be caused by its contact with the masking film 3 even if the chemical resistance of the electro-conductive film 2 itself is large. Moreover, the surface hardness of the electroconductive film may be small, and the durability of the entire photomask can be restricted by that of the electroconductive film 2.

In order to overcome these difficulties, according to preferred embodiments of this invention, there is inserted a translucent and chemically resistant protective film 5 made of one or more materials selected from aluminum oxide, calcium oxide, magnesium oxide, silicon oxide, cerium oxide, tantalum oxide, chromium oxide and titanium oxide, as shown in Figs. 6 and 7. Among these materials, silicon dioxide is the most preferable as a single material. This film has a transmittance desirably of 80 percent or more with respect to light of a wavelength of 200 to 600 nm, particularly 400 to 600 nm. This film is highly resistant to chemicals and protects the aforesaid electroconductive film, thus functioning to prevent the electro-conductive film from being destroyed by repeated washing treatment with acids or alkalis. This film also functions as a barrier, by which the masking film can be effectively protected from deleterious effects due to sodium ions precipitated from a transparent substrate such as that of glass. Further, this film has chemical resistance with respect to an etching solution or an etching gas employed for etching of a masking film to be provided on the film. The thickness of this film is preferably 10 to 100 nm, particularly 5 to 10 nm. With a thickness within such a range, surface electroconductivity can be retained after formation of the protective film 3.

Further, with use of the photomask blank, according to this invention, a photomask can be prepared not only by a wet etching system but also by a dry etching system.

The photomask thus obtained has an electro-conductive film and therefore has ample electroconductivity to avoid destruction of the silicon wafer elements and occurrence of pattern defects in the photomask caused by electrostatic charges at the time of pattern printing. Further, dimensional measurement by an electron-beam system and evaluation of registration of the photomask of this invention are possible.

Furthermore, where the electroconductive film is covered by a chemically resistant protective film, a photomask protected against damage during repeated washing with an acid, alkali or the like is obtained.

In order to indicate more fully the nature and utility of this invention, the following examples are set forth, it being understood that these examples are presented as illustrative only and are not intended to limit the scope of the invention.

Example 1

On a transparent substrate made of soda lime glass of a thickness of 2.3 mm, a Ta film of a thickness of 5 nm was formed by sputtering to constitute a translucent electroconductive film. It should be mentioned that this electroconductive film can also be formed, in general, by a process such as vacuum evaporation or electroless plating. Then, on this Ta film, a masking film made of a thin film of metallic chromium of a thickness of 100 nm was formed in accordance with the sputtering process. Thus, a photomask blank of the construction as indicated in Fig. 1 was fabricated.

Then, on the Ta film of the photomask blank thus fabricated, a photoresist (AZ-1350 mfd. by Shipley Co., Inc.) of a thickness of 0.5 μm was formed. After exposure to light of the photoresist through a circuit pattern, the photoresist was developed by using a developer prescribed therefore thereby to obtain a resist pattern. Then, with an etching liquid comprising 165.0 g of $(NH_4)_2Ce(NO_3)_6$, 43.0 g of $HClO_4$ (70%) and 1,000 ml of pure water, etching of the Cr layer was carried out without essentially any corrosion of the Ta film thereby to form a pattern. Then, by peeling off and removing the resist film, a photomask (hard mask) of this invention as shown in Fig. 5 was obtained.

In the photomask thus obtained, the light-transmittance of the electroconductive film with respect to light of wavelengths of 400 to 550 nm was found to be 80 percent or more, and the sheet resistivity was found to be less than 50 KΩ per square.

Ten of these hard mask materials were fabricated and subjected to a durability test. In this test, pattern transfer onto a photomask blank having a silver emulsion film was carried out 100 times in an atomsphere at a temperature of 22°C and a humidity of 40 percent. As a result, it was found that there was no occurrence of dropping off of the Cr film parts in island-like state in all ten hard mask materials, and there were no defects whatsoever on also the glass substrate surfaces without Cr films.

For comparison, ten hard mask samples of known type obtained by the procedure described above except that the electroconductive film was not formed were subjected to the same test described above. As a result, dropping off of the Cr film pattern occurred in all ten samples with 10 transfers.

Example 2

On a glass plate, a film of tantalum was formed to a thickness of 5 nm according to the electron-beam heated vacuum evaporation method, and then a film of silicon oxide was formed to a thickness of 20 nm according to the electron-beam heated vacuum evaporation method. Further, on the silicon oxide film, a chromium film was formed to a thickness of 100 nm according to the electron-beam heated vacuum evaporation method to produce a photomask blank of this invention.

On the chromium film of the blank as prepared above, a resist (AZ-1350, produced by Shipley Co.) was coated, and then a resist pattern was formed thereon by exposure to light and then developing of the resist. Thereafter, with the use of an etchant having the composition shown below, etching was carried out at a liquid temperature of 20°C for 40 seconds to remove the exposed chromium film portions by etching to produce a desired photomask.

Composition of etchant

| | |
|---|---|
| $(NH_4)_2Ce(NO_3)_6$ | 165.0 g |
| $HClO_4$ (70%) | 43.0 ml |
| Pure water | 1,000 ml |

The following durability tests were conducted on ten sheets of the thus prepared photomask.

The test for chemical resistance was carried out by immersing the photomask in a mixture of conc. sulfuric acid with 20 vol. % of a hydrogen peroxide (30%) aqueous solution under heating at 110°C. As a result, no failure occurred in the electroconductive film with no change whatsoever in electroconductivity.

The test with respect to electrostatic charges was carried out by repeating 100 times pattern transfer onto photomask blanks having silver emulsion coatings in an atmosphere at 22°C at a humidity of 40%. No failure occurred in the photomask.

Example 3

On a glass plate, a film of tantalum was formed to a thickness of 5 nm according to the electron-beam heated vacuum evaporation method, and then a film of silicon oxide was formed to a thickness of 20 nm according to the same deposition method. Further, on the silicon oxide film, a silicon film was formed to a thickness of 100 nm according to the same deposition method to produce a photomask blank of this invention.

On the silicon film of the blank as prepared above, an electron-beam resist (COP, produced by Mead Chemical Co.) was coated. This step was followed by exposure to an electron beam and development of the image formed to form a resist pattern. Thereafter, with the use of an etchant having the composition shown below, etching was carried out at a liquid temperature of 20°C for 2 minutes to remove the exposed silicon film portions to obtain a desired photomask.

Composition of etchant

| | |
|---|---|
| $AgNO_3$ | 1.0 g |
| $NH_4F$ | 0.5 g |
| $HNO_3$ | 100 ml |
| Pure water | 100 ml |

The chemical resistance test and the test with respect to electrostatic charges were conducted similarly as described in Example 3 for ten sheets of the thus prepared photomask.

As a result of the chemical resistance test, no defect was found to occur in the electroconductive film and there was observed no change in electroconductivity. No defect caused by electrostatic charges was observed, either.

For the photomask as prepared above, it was also possible to effect registration of the mask with the use of an electron beam with good precision.

Example 4

A part of the chromium film in the photomask blank as prepared in Example 1 was removed by the dry etching method under the etching conditions shown below to produce a desired photomask.

Etching conditions

| | |
|---|---|
| Etching gas: | mixture of $CCl_4$ and air |
| Gas pressure: | 0.3 Torr |
| High-frequency power applied: | 200 W |
| Etching time: | 5 minutes |

Example 5

On a glass plate, a film of chromium was formed to a thickness of 5 nm according to the electron-beam heated vacuum evaporation method, and then a film of silicon oxide was formed to a thickness of 20 nm according to the same method. Further, a tantalum film was formed on the silicon oxide film to a thickness of 100 nm according to the electron-beam heated vacuum evaporation method to obtain a desired photomask blank.

A part of the tantalum film in the blank as prepared above was removed by etching according to the dry etching method under the following etching conditions to obtain a desired photomask.

Etching conditions

| | |
|---|---|
| Etching gas: | $CF_4$ |
| Gas pressure: | 0.01 Torr |
| High-frequency power applied: | 300 W |
| Etching time | 2 minutes |

Example 6

A part of the silicon film in the photomask blank as prepared in Example 3 was removed by etching according to the dry etching method under the following etching conditions to obtain a desired photomask.

Etching conditions

| Etching gas: | CCl$_4$ |
|---|---|
| Gas pressure: | 0.02 Torr |
| High-frequency power applied: | 250 W |
| Etching time: | one minute |

**Example 7**

On a glass plate, a chromium film was formed to a thickness of 5 nm according to the electron-beam heating system vapor deposition method, and then a film of silicon oxide was formed thereon to a thickness of 20 nm according to the same method. Further, on the silicon oxide film, a silicon film was formed to a thickness of 100 nm to obtain a photomask blank.

Following the procedures as described in Example 4, a part of the silicon film in the blank as prepared above was removed by etching to produce a desired photomask.

**Example 8**

A part of the silicon film in the blank as prepared in Example 7 was removed by etching according to the dry etching method under the following conditions.

Etching conditions

| Etching gas: | CCl$_4$ |
|---|---|
| Gas pressure: | 0.02 Torr |
| High-frequency power applied: | 250 W |
| Etching time | one minute |

With the use of ten sheets for each of the photomasks as prepared in Examples 4 to 8, the chemical resistance test and the test with respect to electrostatic charges were conducted similarly as described in Example 2. As a result of the chemical resistance tests, no defect was found to have developed in any of the photomasks, without change in electroconductivity. Further, no defect was observed to be caused by electrostatic charges.

## Claims

1. A photomask blank comprising a transparent substrate (1), a metallic film (2) of Ta on the substrate (1), and a masking film (3) comprising at least one layer of a masking material selected from the group consisting of metallic chromium and chromium oxide and combination thereof on the metallic film (2).

2. A photomask blank comprising a transparent substrate (1), a metallic film (2) of Cr on the substrate (1) and a masking film (3) comprising at least one layer of a masking material selected from the group consisting of metallic tantalum and tantalum oxide and combination thereof on the metallic film (2).

3. A photomask blank according to claim 1 or 2 in which the film has a transmittance of at least 60 percent with respect to light of a wavelength of 400 to 550 nm and a sheet resistivity of at most 50 KΩ per square and has a thickness of 1 to 20 nm.

4. A photomask blank comprising a transparent substrate (1), a metallic film (2) of a translucent and electroconductive material selected from the group consisting of Mo, Nb, Ta, Ti, V, W, Cr, Zr and Au on the substrate (1), a chemically resistant and translucent protective film (5) of a material selected from the group consisting of aluminum oxide, calcium oxide, magnesium oxide, silicon oxide, silicon nitride, cerium oxide, tantalum oxide, chromium oxide, and titanium oxide on the metallic film (2), and a masking film (4) comprising at least one layer of a masking material selected from the group consisting of metallic chromium, chromium oxide, chromium nitride, metallic silicon, iron oxide, metallic tantalum, tantalum oxide, tantalum nitride and combinations thereof on the protective film (5).

5. A photomask blank according to claim 4 in which the protective film has a thickness of 1 to 100 nm and a transmittance of 80% or more with respect to light of a wavelength of 400 to 600 nm.

6. A photomask blank according to claim 4 or 5 in which the protective film is made of silicon oxide.

7. A photomask comprising a transparent substrate (1), a metallic film (2) of Ta on the substrate (1), and a patternized masking film (3a) comprising at least one layer of a masking material selected from the group consisting of metallic chromium and chromium oxide and combination thereof on the metallic film (2).

8. A photomask comprising a transparent substrate (1), a metallic film (2) of Cr on the substrate (1), and a patternized masking film (3a) comprising at least one layer of a masking material selected from the group consisting of metallic tantalum and tantalum oxide and combination thereof on the metallic film (2).

9. A photomask according to claim 7 or 8 in which the metallic film has a transmittance of at least 60 percent with respect to light of a wavelength of 400 to 550 nm and a sheet resistivity of at most 50 KΩ per square and has a thickness of 1 to 20 nm.

10. A photomask according to claim 7, 8 or 9 in which the masking film has been patternized by etching, and the metallic film has a characteristic of undergoing substantially no attack by the etching.

11. A photomask according to claim 7, 8, 9 or 10 in which the masking film includes parts in the state of islands isolated from other parts of the same film.

12. A photomask comprising a transparent substrate (1), a metallic film (2) of a translucent and electroconductive material selected from the group consisting of Mo, Nb, Ta, Ti, V, W, Cr, Zr and Au on the substrate (1), a chemically resistant and translucent protective film (5) of a material selected from the group consisting of aluminum oxide, calcium oxide, magnesium oxide, silicon oxide, silicon nitride, cerium oxide, tantalum oxide, chromium oxide, and titanium oxide on the metallic film (2), and a patternized masking film (3a) comprising at least one layer of a masking material selected from the group consisting of metallic chromium, chromium oxide, chromium nitride, metallic silicon, iron oxide, metallic tantalum, tantalum oxide, tantalum nitride and combinations thereof on the protective film (5).

13. A photomask blank according to claim 12 in which the protective film has a thickness of 10 to 100 nm and a transmittance of 80% or more with respect to light of a wavelength of 400 to 600 nm.

14. A photomask blank according to claim 12 or 13 in which the protective film is made of silicon oxide.

**Patentansprüche**

1. Blankophotoschablone, dadurch gekennzeichnet, dass sie aus einem transparenten Substrat (1), einem daraufliegenden metallischen Film (2) aus Tantalium und einem auf dem metallischen Film (2) aufgebrachten Schablonenfilm (3) aus Schablonenmaterial, ausgewählt aus der Gruppe aus metallischem Chrom und Chromoxid sowie Kombinationen davon, besteht.

2. Blankophotoschablone, dadurch gekennzeichnet, dass sie aus einem transparenten Substrat (1), einem daraufliegenden metallischen Film (2) aus Tantal und einem auf dem metallischen Film (2) aufgebrachten Schablonenfilm (3) aus Schablonenmaterial, ausgewählt aus der Gruppe aus metallischem Tantal und Tantaloxid sowie Kombinationen davon, besteht.

3. Blankophotoschablone nach Anspruch 1 oder 2, dadurch gekennzeichnet, dass der Film eine Durchlässigkeit von wenigstens 60% für Licht mit einer Wellenlänge zwischen 400 und 550 nm, einen Flächenwiderstand von höchstens 50 k$\Omega$/m$^2$ und eine Dicke zwischen 1 und 20 nm hat.

4. Blankophotoschablone, dadurch gekennzeichnet, dass sie aus einem transparenten Substrat (1), einem metallischen Film (2) auf dem Substrat (1) aus einem lichtdurchlässigen und elektrisch leitenden Material, ausgewählt aus einer Gruppe, bestehend aus Mo, Nb, Ta, Ti, V, W, Cr, Zr und Au, einem chemisch resistenten und lichtdurchlässigen Schutzfilm (5) auf dem metallischen Film (2), aus einem Material, ausgewählt aus einer Gruppe, bestehend aus Aluminiumoxid, Kalziumoxid, Magnesiumoxid, Siliziumoxid, Siliziumnitrid, Zeriumoxid Tantaloxid, Chromoxid und Titanoxid und einem Schablonenfilm (4), bestehend aus wenigstens einer Schicht von Schablonenmaterial auf dem Schutzfilm (4) ausgewählt aus einer Gruppe, bestehend aus metallischem Chrom, Chromoxid, Chromnitrid, metallischem Silizium, Eisenoxid, metallischem Tantal, Tantaloxid, Tantalnitrid und Kombinationen davon, besteht.

5. Blankophotoschablone nach Anspruch 4, dadurch gekennzeichnet, dass der Schutzfilm (5) eine Dicke zwischen 1 und 100 mm und eine Durchlässigkeit von 80% oder mehr für Licht mit einer Wellenlänge zwischen 400 bis 600 mm hat.

6. Blankophotoschablone nach Anspruch 4 oder 5, dadurch gekennzeichnet, dass der Schutzfilm (5) aus Siliziumoxid besteht.

7. Photoschablone, dadurch gekennzeichnet, dass sie aus einem transparenten Substrat (1), einem metallischen Film (2) aus Ta auf dem Substrat (1) und einem mit schablonenartigen Ausnehmungen versehenen Schablonenfilm (3a), bestehend aus wenigstens einer Schicht von Schablonenmaterial auf dem metallischen Film (2), ausgewählt aus einer Gruppe, bestehend aus metallische Chrom und Chromoxid und Kombinationen davon, besteht.

8. Photoschablone, dadurch gekennzeichnet, dass sie aus einem transparenten Substrat (1), einem mit schablonenartigen Ausnehmungen versehenen Schablonenfilm (3a), bestehend aus wenigstens einer Schicht von Schablonenmaterial auf dem metallischen Film (2), ausgewählt aus einer Gruppe, bestehend aus metallischem Tantal und Tantaloxid und Kombinationen davon, besteht.

9. Photoschablone nach Anspruch 7 oder 8, dadurch gekennzeichnet, dass der metallische Film (2) eine Durchlässigkeit von wenigstens 60% für Licht mit einer Wellenlänge zwischen 400 und 500 nm, einen Flächenwiderstand von höchstens 50 k$\Omega$/m$^2$ und eine Dicke zwischen 1 und 20 nm hat.

10. Blankphotoschablone nach Anspruch 7, 8 oder 9, dadurch gekennzeichnet, dass die schablonenartigen Ausnehmungen des Schablonenfilms (3) durch Aetzen herausgenommen wurden und dass der metallische Film (2) so beschaffen ist, dass er durch das Aetzen nicht beschädigt wird.

11. Photoschablone nach Anspruch 7, 8, 9 oder 10, dadurch gekennzeichnet, dass der Schablonenfilm (3) Teile umfasst, die in der Form von Inseln völlig isoliert von den andern Teilen des Schablonenfilms zu ihm gehören.

12. Photoschablone, dadurch gekennzeichnet, dass die aus einem transparenten Substrat (1), einem metallischem Film (2) auf dem Substrat (1) aus lichtdurchlässigem und elektrisch leitendem Material, ausgewählt aus einer Gruppe, bestehend aus Mo, Nb, Ta, V, W, Cr, Zr und Au, einem chemisch resistenten und lichtdurchlässigen Schutzfilm (5) auf dem metallischen Film (2), bestehend aus einem Material, ausgewählt aus einer Gruppe, bestehend aus Alumiumoxid, Kalziumoxid, Magnesiumoxid, Siliziumoxid, Siliziumnitrid, Zeriumoxid, Tantaloxid, Chromoxid und Titanoxid und einem mit schablonenartigen Ausnehmungen versehenen Schablonenfilm (3a), bestehend aus wenigstens einer Schicht aus Schablonenmaterial auf dem Schutzfilm (5), ausgewählt aus einer Gruppe, bestehend aus metallischem Chrom, Chromoxid, Chromnitrid, metallischem Silizium, Eisenoxid, metallischem Tantal, Tantaloxid, Tantalnitrid und Kombinationen davon, besteht.

13. Photoschablone nach Anspruch 12, dadurch gekennzeichnet, dass der Schutzfilm (5) eine Dicke zwischen 10 und 100 nm und eine Durchlässigkeit von 80% oder mehr für Licht mit einer Wellenlänge zwischen 400 und 600 nm hat.

14. Photoschablone nach Anspruch 12 oder 13, dadurch gekennzeichnet, dass der Schutzfilm aus Siliziumoxid besteht.

**Revendications**

1. Photoréserve vierge, caractérisée en ce qu'elle comprend un substrat transparent (1), une couche métallique (2) de Ta sur le substrat (1), et une couche de masquage (3) comprenant au moins une couche d'un matériau de masquage, choisi dans le groupe composé du chrome métallique et de l'oxyde de chrome et de leur combinaison, sur la couche métallique (2).

2. Photoréserve vierge, caractérisée en ce qu'elle comprend un substrat transparent (1), une couche métallique (2) de Cr sur le substrat (1), et une couche de masquage (3) comprenant au moins une couche d'un matériau de masquage, choisi dans le groupe composé du tantale métallique et de l'oxyde de tantale et de leur combinaison, sur la couche métallique (2).

3. Photoréserve vierge selon l'une quelconque des revendications 1 et 2, caractérisée en ce que la couche a un coefficient de transmission au moins égal à 60% par rapport à de la lumière de longueur d'onde comprise entre 400 et 550 nanomètres et une résistivité de couche au plus égale à 50 KΩ/carré et a une épaisseur comprise entre 1 et 30 nanomètres.

4. Photoréserve vierge, caractérisée en ce qu'elle comprend un substrat transparent (1), une couche métallique (2) d'un matériau translucide et électriquement conducteur, choisi dans le groupe composé de Mo, Nb, Ta, Ti, V, W, Cr, Zr et Au, sur le substrat (1), une couche protectrice (5) chimiquement résistante et translucide d'un matériau, choisi dans le groupe composé de l'oxyde d'aluminium, de l'oxyde de calcium, de l'oxyde de magnésium, de l'oxyde de silicium, du nitrure de silicium, de l'oxyde de cérium, de l'oxyde de tantale, de l'oxyde de chrome, et de l'oxyde de titane, sur la couche métallique (2), et une couche de masquage (4) comprenant au moins une couche d'un matériau de masquage, choisi dans le groupe composé du chrome métallique, de l'oxyde de chrome, du niture de chrome, du silicium métallique, de l'oxyde de fer, du tantale métallique, de l'oxyde de tantale, du nitrure de tantale et de leurs combinaisons, sur la couche protectrice (5).

5. Photoréserve vierge selon la revendication 4, caractérisée en ce que la couche protectrice a une épaisseur comprise entre 1 et 100 nanomètres et un coefficient de transmission égal à 80% ou plus par rapport à de la lumière de longueur d'onde comprise entre 400 et 600 nanomètres.

6. Photoréserve vierge selon l'une quelconque des revendications 4 et 5, caractérisée en ce que la couche protectrice est constituée d'oxyde de silicium.

7. Photomasque, caractérisé en ce qu'il comprend un substrat transparent (1), une couche métallique (2) de Ta sur le substrat (1), et une couche de masquage (3a) dessinée comprenant au moins une couche d'un matériau de masquage, choisi dans le groupe composé du chrome métallique et de l'oxyde de chrome et de leur combinaison, sur la couche métallique (2).

8. Photomasque, caractérisé en ce qu'il comprend un substrat transparent (1), une couche métallique (2) de Cr sur le substrat (1), et une couche de masquage (3a) dessinée comprenant au moins une couche d'un matériau de masquage, choisi dans le groupe composé du tantale métallique et de l'oxyde de tantale et de leur combinaison, sur la couche métallique (2).

9. Photomasque selon l'une quelconque des revendications 7 et 8, caractérisé en ce que la couche métallique a un coefficient de transmission au moins égal à 60% par rapport à de la lumière de longueur d'onde comprise entre 400 et 550 nanomètres et une résistivité de couche au plus égale à 50 KΩ/carré et a une épaisseur comprise entre 1 et 20 nanomètres.

10. Photomasque selon l'une quelconque des revendications 7 à 9, caractérisé en ce que la couche de masquage a été dessinée par attaque, et en ce que la couche métallique a la caractéristique de ne pas subir essentiellement d'attaque par l'opération d'attaque.

11. Photomasque selon l'une quelconque des revendications 7 à 10, caractérisé en ce que la couche de masquage comprend des parties dans l'état d'îles isolées des autres parties de la même couche.

12. Photomasque, caractérisé en ce qu'il comprend un substrat transparent (1), une couche métallique (2) d'un matériau translucide et électriquement conducteur, choisi dans le groupe composé de Mo, Nb, Ta, Ti, V, W, Cr, Ze et Au, sur le substrat (1), une couche protectrice (5) chimiquement résistante et translucide d'un matériau, choisi dans le groupe composé de l'oxyde d'aluminium, de l'oxyde de calcium, de l'oxyde de magnésium, de l'oxyde de silicium, du nitrure de silicium, de l'oxyde de cérium, de l'oxyde de tantale, de l'oxyde de chrome, et de l'oxyde de titane, sur la couche métallique (2), et une couche de masquage (3a) dessinée comprenant au moins une couche d'un matériau de masquage, choisi dans le groupe composé du chrome métallique, de l'oxyde de chrome, du nitrure de chrome, du silicium métallique, de l'oxyde de fer, du tantale métallique, de l'oxyde de tantale, du nitrure de tantale et de leurs combinaisons, sur la couche protectrice (5).

13. Photoréserve vierge selon la revendication 12, caractérisée en ce que la couche protectrice a une épaisseur comprise entre 10 et 100 nanomètres et un coefficient de transmission égal à 80% ou plus par rapport à de la lumière de longueur d'onde comprise entre 400 et 600 nanomètres.

14. Photoréserve vierge selon l'une quelconque des revendications 12 et 13, caractérisée en ce que la couche protectrice est constituée d'oxyde de silicium.

FIG. I

A

3
2
1

FIG. 5

B

3a
2
1

FIG. 2

4
3
2
1

FIG. 6

3
5
2
1

FIG. 3

4a
3
2
1

FIG. 7

3a
5
2
1

FIG. 4

4a
3a
2
1